# EUROPEAN PATENT APPLICATION

(11) **EP 4 459 306 A1**
(43) Date of publication of application: **06.11.2024**
(21) Application number: 22913292.3
(22) Date of filing: 11.07.2022
(51) Int. Cl.: G01R 31/56, G01R 19/165, G01R 19/17

(54) **HARDWARE FAULT DIAGNOSIS METHOD AND APPARATUS FOR DCDC CONVERSION MODULE, AND STORAGE MEDIUM**

(30) Priority: 28.12.2021 CN 202111627461
(71) Applicant: United Automotive Electronic Systems Co., Ltd., Pudong New Area Shanghai 201206 (CN)
(72) Inventor: SHAO, Nan, Shanghai 201206 (CN); HUANG, Hao, Shanghai 201206 (CN); HAN, Wei, Shanghai 201206 (CN); WEI, Bin, Shanghai 201206 (CN); XU, Lei, Shanghai 201206 (CN); SHEN, Hechun, Shanghai 201206 (CN)
(74) Representative: Bjerkén Hynell KB
(86) International application number: PCT/CN2022/104805
(87) International publication number: WO 2023/124003

(57) **Abstract**

The present application provides a hardware failure diagnosis method and apparatus for a DCDC conversion module, and a storage medium. The DCDC conversion module comprises: a first branch circuit and a second branch circuit which are connected in parallel. The hardware failure diagnosis method for the DCDC conversion module comprises: collecting currents and voltages of input ends and output ends of a first branch circuit and a second branch circuit; according to the currents and the voltages, determining whether a hardware failure occurs; physically turning off the branch circuit having the hardware failure; logically turning off the two branch circuits, and entering a temporary failure mode; and controlling, at least once, the first branch circuit and/or the second branch circuit to exit the temporary failure mode. According to the present application, the first branch circuit and the second branch circuit which are connected in parallel are provided on the DCDC conversion module, so that the other branch circuit without the hardware failure can exit from the temporary failure mode and normally maintain power output under the condition that one branch circuit has the hardware failure, and the driving safety of the whole vehicle is ensured.

## Description

### TECHNICAL FIELD

The present application relates to the technical field of automobile electronic control, and in particular to a hardware failure diagnosis method and apparatus for a DCDC conversion module, and a storage medium.

### BACKGROUND

The 48 volt mild hybrid system is widely applied in the field of new energy vehicles. In this system with a voltage of 48 volt, a power lithium-ion battery with energy less than 1 kilowatt-hour may be used to substitute the conventional lead acid battery, and a Belt-Driven Starter Generator (BSG) motor is used to substitute the conventional starter motor and generator. In addition to an automatic start-stop function, the mild hybrid system may also provide auxiliary power when necessary. As one of core components of a 48 volt start-stop system, a bidirectional DCDC converter plays an important role in the system, which is compatible with the conventional automobile 12 volt supply system and responsible for a bidirectional energy transfer.

There are generally two solutions for the mainstream 48 volt DCDC converter system. In solution I: the hardware is implemented by a multi-phase parallel topology with a single master chip, using one set of output and protection logic. In solution II: the hardware is implemented by two DCDC converters that are directly connected in parallel for backup with each other; the software requires two master chips, using two sets of output and protection logic.

However, there are some problems in both solutions:
(1) In solution I, since the DCDC converter has a single input circuit and a single output circuit, when a hardware failure occurs, for example, when a short-circuit or open-circuit failure occurs in a MOSFET in any phase, the whole DCDC converter is incapable of a normal output, causing the entire vehicle to be unable to operate normally.
(2) In solution II, when a hardware failure occurs in any one of the DCDC converters and causes the DCDC converter to be incapable of a power output, although the two DCDC converters connected in parallel can perform backup for each other and the other DCDC converter in which no failure occurs is capable of a normal output, it is required to add a complete controller, thereby increasing the cost significantly.

In some examples, current hardware failure diagnosis methods for DCDC converters are all based on the DCDC converter in solution I or solution II, each having problems of low hardware failure diagnostic efficiency and inability to independently diagnose hardware failures of the DCDC converters on parallel branches.

In order to solve the problems in solution I and solution II and to solve problems such as low diagnosis efficiency and inability to independently diagnose hardware failures of the DCDC converters on parallel branches in the current hardware failure diagnosis methods for DCDC converters, there is an urgent demand to propose a hardware failure diagnosis method based on a novel bidirectional DCDC converter.

### BRIEF SUMMARY

The present application provides a hardware failure diagnosis method and apparatus for a DCDC conversion module, and a storage medium, to solve at least one of the following problems: in the case of a hardware failure, a DCDC converter is incapable of a normal power output or capable of a power output with an excessively high cost, and the hardware failure diagnosis efficiency is low.

In one aspect, embodiments of the present application provide a hardware failure diagnosis method for a DCDC conversion module, the DCDC conversion module including: a first branch and a second branch connected in parallel; the hardware failure diagnosis method for the DCDC conversion module including:
setting a first threshold current, a second threshold current, a first threshold voltage, and a second threshold voltage;
collecting a first actual current and a first actual voltage of an input as well as a second actual current and a second actual voltage of an output of the first branch, a third actual current and a third actual voltage of an input as well as a fourth actual current and a fourth actual voltage of an output of the second branch;
comparing the first to second threshold voltages with the first to fourth actual voltages, and comparing the first to second threshold currents with the first to fourth actual currents, to determine whether a hardware failure occurs in at least one of the first branch or the second branch;
when the hardware failure occurs in the at least one of the first branch or the second branch, physically turning off the at least one of the first branch or the second branch in which the hardware failure occurs; logically turning off the first branch or the second branch in which no hardware failure occurs, such that the first branch and the second branch both enter a temporary failure mode; and
controlling, at least once, the at least one of the first branch or the second branch to exit the temporary failure mode, wherein the at least one of the first branch or the second branch that succeeds in exiting the temporary failure mode recovers a normal mode, and the at least one of the first branch or the second branch that fails in exiting the temporary failure mode enters a permanent failure mode.

Optionally, in the hardware failure diagnosis method for a DCDC conversion module, the hardware failure includes: a hardware damage failure and a non-hardware damage failure.

Optionally, in the hardware failure diagnosis method for a DCDC conversion module, the step of controlling, at least once, the at least one of the first branch or the second branch to exit the temporary failure mode includes:
the first step: setting a failure recovery count threshold;
the second step: respectively obtaining a first failure recovery count of the first branch and a second failure recovery count of the second branch;
the third step: respectively comparing the first failure recovery count and the second failure recovery count with the count threshold, and performing the fourth step if at least one of the first failure recovery count or the second failure recovery count is less than or equal to the count threshold; performing the seventh step if the first failure recovery count and the second failure recovery count are both greater than the count threshold;
the fourth step: performing an attempt to recover normal operation of the at least one of the first branch or the second branch, and if recovery of the normal operation of the at least one of the first branch or the second branch succeeds, diagnosing the temporary failure mode as the non-hardware damage failure, performing the fifth step, and adding 1 to the failure recovery count of the at least one of the first branch or the second branch at the same time; if the recovery of the normal operation of the at least one of the first branch or the second branch does not succeed, diagnosing the temporary failure mode as the hardware damage failure, and performing the seventh step;
the fifth step: monitoring whether there is an anomaly in any one or multiple parameters among the first to fourth actual voltages and the first to fourth actual currents are abnormal, and returning to the second step if there is an anomaly in any one or multiple parameters among the first to fourth actual voltages and the first to fourth actual currents; performing the sixth step if all parameters are normal;
the sixth step: recovering the normal mode of the at least one of the first branch or the second branch that succeeds in exiting the temporary failure mode, and setting the failure recovery count of the at least one of the first branch or the second branch to zero at the same time; and
the seventh step: entering the permanent failure mode of the at least one of the first branch or the second branch that fails in exiting the temporary failure mode.

Optionally, in the hardware failure diagnosis method for a DCDC conversion module, after the recovering the normal mode of the first branch or the second branch that succeeds in exiting the temporary failure mode, the hardware failure diagnosis method for a DCDC conversion module also includes:
halving a value of preset maximum desired output power in the DCDC conversion module.

Optionally, in the hardware failure diagnosis method for a DCDC conversion module, the first branch includes: a first input side switch unit, a first power conversion unit, and a first output side switch unit connected in sequence; the second branch includes: a second input side switch unit, a second power conversion unit, and a second output side switch unit connected in sequence.

Optionally, in the hardware failure diagnosis method for a DCDC conversion module, the controlling, at least once, the at least one of the first branch or the second branch to exit the temporary failure mode includes: controlling the first input side switch unit and the first output side switch unit to be on and controlling the first power conversion unit to output power normally, and/or controlling the second input side switch unit and the second output side switch unit to be on and controlling the second power conversion unit to output power normally.

Optionally, in the hardware failure diagnosis method for a DCDC conversion module, the physically turning off the at least one of the first branch or the second branch in which the hardware failure occurs includes: turning off the first input side switch unit and the first output side switch unit and turning off the first power conversion unit, and/or turning off the second input side switch unit and the second output side switch unit and turning off the second power conversion unit;
the logically turning off the first branch or the second branch in which no hardware failure occurs includes: controlling the first input side switch unit and the first output side switch unit to be off and controlling the first power conversion unit to stop outputting power, and/or controlling the second input side switch unit and the second output side switch unit to be off and controlling the second power conversion unit to stop outputting power.

Optionally, in the hardware failure diagnosis method for a DCDC conversion module, the step of comparing the first to second threshold voltages with the first to fourth actual voltages, and comparing the first to second threshold currents with the first to fourth actual currents, to determine whether a hardware failure occurs in at least one of the first branch or the second branch includes:
comparing the first actual current and the third actual current with the first threshold current, comparing the second actual current and the fourth actual current with the second threshold current, comparing the first actual voltage and the third actual voltage with the first threshold voltage, and comparing the second actual voltage and the fourth actual voltage with the second threshold voltage; if at least one of the first actual current or the third actual current is greater than the first threshold voltage, or if at least one of the first actual voltage or the third actual voltage is greater than the first threshold voltage, diagnosing the hardware failure as occurring in the first branch; and if at least one of the second actual current or the fourth actual current is greater than the second threshold current, or if at least one of the second actual voltage or the fourth actual voltage is greater than the second threshold voltage, diagnosing the hardware failure as occurring in the second branch.

Optionally, in the hardware failure diagnosis method for a DCDC conversion module, the fifth step in the step of controlling, at least once, the at least one of the first branch or the second branch to exit the temporary failure mode includes:
comparing the first actual current and the third actual current with the first threshold current, comparing the second actual current and the fourth actual current with the second threshold current, comparing the first actual voltage and the third actual voltage with the first threshold voltage, and comparing the second actual voltage and the fourth actual voltage with the second threshold voltage; if at least one of the first actual current or the third actual current is greater than the first threshold voltage, or if at least one of the first actual voltage or the third actual voltage is greater than the first threshold voltage, or if at least one of the second actual current or the fourth actual current is greater than the second threshold current, or if at least one of the second actual voltage or the fourth actual voltage is greater than the second threshold voltage, returning to the second step; and if the first actual current and the third actual current are less than equal to the first threshold voltage, the first actual voltage and the third actual voltage are less than equal to the first threshold voltage, the second actual current and the fourth actual current are less than equal to the second threshold current, and the second actual voltage and the fourth actual voltage are less than equal to the second threshold voltage, performing the sixth step.

Optionally, in the hardware failure diagnosis method for a DCDC conversion module, upon entry of the at least one of the first branch or the second branch into the permanent failure mode, the DCDC conversion module obtains an off state of the at least one of the first branch or the second branch and feeds back the off state to a Vehicle control unit; and when the at least one of the first branch or the second branch succeeds in recovering the normal mode, the DCDC conversion module obtains a failure recovery state of the at least one of the first branch or the second branch and feeds back the failure recovery state to the Vehicle control unit.

Optionally, in the hardware failure diagnosis method for a DCDC conversion module, the DCDC conversion module also includes: a first transient current suppression module and a second transient current suppression module, the first transient current suppression module being connected to inputs of the first branch and the second branch connected in parallel, and the second transient current suppression module being connected to outputs of the first branch and the second branch connected in parallel.

In other aspects, embodiments of the present application also provide a hardware failure diagnosis apparatus for a DCDC conversion module, the DCDC conversion module including: a first branch and a second branch connected in parallel; the hardware failure diagnosis apparatus for the DCDC conversion module including:
a collection unit configured to collect a first actual current and a first actual voltage of an input as well as a second actual current and a second actual voltage of an output of the first branch, a third actual current and a third actual voltage of an input as well as a fourth actual current and a fourth actual voltage of an output of the second branch;
an overvoltage and overcurrent protection unit configured to compare the first to second threshold voltages with the first to fourth actual voltages, compare the first to second threshold currents with the first to fourth actual currents, to determine whether a hardware failure occurs in at least one of the first branch or the second branch, and output a failure signal to a rear stage if the hardware failure occurs;
a control unit configured to control logic turning-off of the first branch or the second branch, and control, at least once, the at least one of the first branch or the second branch to exit a temporary failure mode; and
a drive unit configured to receive the failure signal sent by the overvoltage and overcurrent protection unit, physically turn off the at least one of the first branch or the second branch in which the hardware failure occurs, receive a first control signal sent by the control unit to logically turn off the first branch or the second branch in which no hardware failure occurs, and receive a second control signal sent by the control unit to control, at least once, the at least one of the first branch or the second branch to exit the temporary failure mode.

In other aspects, embodiments of the present application also provide a computer-readable storage medium, the storage medium having at least one instruction, at least one program, a code set, or an instruction set stored therein, the at least one instruction, the at least one program, the code set, or the instruction set being loaded and executed by a processor to implement the hardware failure diagnosis method for a DCDC conversion module.

The technical solutions of the present application include at least the following advantages:
In the present application, the first branch and the second branch connected in parallel are provided in the DCDC conversion module, such that when the hardware failure occurs in one or both of the branches, a branch in which the hardware failure occurs is physically turned off first, then both of the branches are logically turned off by means of software, and finally, the failure is diagnosed logically by means of software and at least one of the recoverable branch in which the hardware failure occurs or the branch in which no hardware failure occurs is recovered.

In some examples, in the present application, the first branch and the second branch that are connected in parallel and that each output power independently are provided in the DCDC conversion module, the two branches can share one set of control system, such that when a hardware failure occurs in one of the branches, the other branch in which no hardware failure occurs can exit the temporary failure mode and maintain a power output normally, thereby ensuring the traveling safety of an entire vehicle and reducing a hardware cost of the DCDC conversion module at same time.

### BRIEF DESCRIPTION OF THE DRAWINGS

In order to more clearly explain specific implementations of the present application or technical solutions in the prior art, drawings required in descriptions of the specific implementations or the prior art will be briefly described below. It is obvious that the drawings described below are some of the implementations of the present application, and a person skilled in the art may also obtain other drawings on the basis of these drawings without the practice of inventive effort.
FIG. 1 illustrates a schematic diagram of a circuit of a DCDC conversion module according to an embodiment of the present application;
FIG. 2 illustrates a flowchart of a hardware failure diagnosis method for a DCDC conversion module according to an embodiment of the present application; and
FIG. 3 illustrates a schematic diagram of a structure of a hardware failure diagnosis apparatus for a DCDC conversion module according to an embodiment of the present application.

### List of reference numerals:

101-first transient current suppression module, 102-second transient current suppression module;
10-first branch, 11-first input side switch unit, 12-first power conversion unit, 13-first output side switch unit, 14-first filter unit, 15-second filter unit;
20-second branch, 21-second input side switch unit, 12-second power conversion unit, 13-second output side switch unit, 14-third filter unit, 15-fourth filter unit;
201-DCDC conversion module, 202-collection unit, 203-overvoltage and overcurrent protection unit, 204-control unit, 205-drive unit.

### DETAILED DESCRIPTION OF THE DISCLOSURE

The technical solutions of the present application will be clearly and completely described below with reference to the drawings. Obviously, the described embodiments are part of the embodiments of the present application, rather than all of them. Based on the embodiments in the present application, all other embodiments obtained by a person skilled in the art without the practice of inventive effort shall fall into the scope of protection of the present application.

It should be noted that, in the description of the present application, the orientation or positional relationship indicated by the terms, such as "center", "upper", "lower", "left", "right", "vertical", "horizontal", "inner", and "outer", are based on the orientation or positional relationship shown in the drawings, which is merely for ease of describing the present application and simplifying the description instead of indicating or implying that the indicated apparatus or element necessarily has a particular orientation or is constructed and operated in a particular orientation, and therefore, should not be construed as limitations to the present application. Moreover, the terms such as "first", "second" and "third" are merely used for the illustrative purpose, and should not be construed as indicating or implying relative importance.

In addition, it should also be noted that in the description of the present application, the terms "mount", "couple" and "connect" should be interpreted in a broad sense unless otherwise explicitly defined and limited. For example, the terms may indicate a fixed connection, a detachable connection, or an integral connection; may indicate a mechanical connection or an electrical connection; may indicate a direct connection or an indirect connection implemented via an intermediate medium, or internal communication between two elements; and may indicate a wireless connection or a wired connection. For a person skilled in the art, the specific meanings of the above terms in the present application may be interpreted according to specific situations.

In some examples, the technical features involved in different embodiments of the present application described below can be combined with each other in the case of no conflicts.

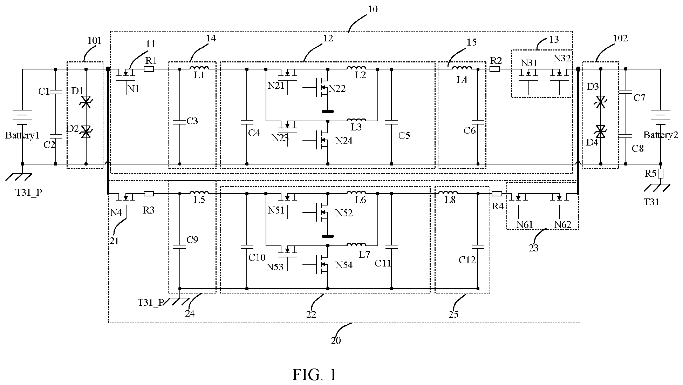

Firstly, referring to FIG. 1, FIG. 1 illustrates a schematic diagram of a circuit of a DCDC conversion module according to an embodiment of the present application. The DCDC conversion module in this embodiment of the present application is a bidirectional DCDC conversion module, and the DCDC conversion module includes: a first branch 10 and a second branch 20 connected in parallel, a first transient current suppression module 101, and a second transient current suppression module 102. In this embodiment, the first branch 10 and the second branch 20 may be identical. The first transient current suppression module 101 is connected to inputs of the first branch 10 and the second branch 20 connected in parallel, and the second transient current suppression module 102 is connected to outputs of the first branch 10 and the second branch 20 connected in parallel. The first branch 10 includes: a first input side switch unit 11, a first power conversion unit 12, and a first output side switch unit 13 connected in sequence, where the first input side switch unit 11 may be an NMOS transistor N1, the first output side switch unit 13 may be two NMOS transistors N31 and N32 connected in series, and the first power conversion unit 12 includes two BUCK/BOOST circuits connected in parallel and two energy storage units C4 and C5 respectively at two sides of the two BUCK/BOOST circuits connected in parallel. Similarly, the second branch 20 includes: a second input side switch unit 21, a second power conversion unit 22, and a second output side switch unit 23 connected in sequence, where the second input side switch unit 21 may be an NMOS transistor N1, the second output side switch unit 23 may be two NMOS transistors N61 and N62 connected in series, and the second power conversion unit 22 includes two BUCK/BOOST circuits connected in parallel and two energy storage units C10 and C11 respectively at two sides of the two BUCK/BOOST circuits connected in parallel. In this embodiment, in each of the first power conversion unit 12 and the second power conversion unit 22, the number of parallel capacitor branches in the energy storage units at two sides of the two BUCK/BOOST circuits connected in parallel may be determined according to actual situations, and this embodiment imposes no limitations thereto. In each of the first power conversion unit 12 and the second power conversion unit 22, the BUCK/BOOST circuits play a role of energy regulation, which is mainly used to regulate input high-voltage energy Battery1 (e.g., 48 volt) into a low-voltage energy (e.g., 12 volt or 5 volt, etc.) output for use by a rear stage power consumption system, or used to regulate low-voltage energy (e.g., 12 volt or 5 volt, etc.) into high-voltage energy (e.g., 48 volt). A rear stage Battery2 is equivalent to a power consumption load, and serves as a constant-voltage system for a rear stage system, which is also referred to as a power supply system. A plurality of BUCK/BOOST circuits are connected in parallel to improve a load carrying capacity of a power supply.

In this embodiment, the first transient current suppression module 101 includes: two transient diodes D1 and D2 connected in series. The second transient current suppression module 102 includes: two transient diodes D3 and D4 connected in series.

In some examples, the first branch 10 also includes: a first filter unit 14 and a second filter unit 15, where the first filter unit 14 includes: a capacitor C3 and an inductor L1, and similarly, the second filter unit 15 includes: a capacitor C6 and an inductor L4.

In some examples, the first branch 10 also includes: a first input side shunt resistor R1 and a first output side shunt resistor R2. The first input side shunt resistor R1 is connected in series between the first input side switch unit 11 and the first filter unit 14, and the first output side shunt resistor R2 is connected in series between the second filter unit 15 and the first output side switch unit 13.

Referring to FIG. 1, in the DCDC conversion module of this embodiment of the present application, the first branch 10 and the second branch 20 share the first transient current suppression module 101, the second transient current suppression module 102, and some filter capacitors C1, C2, C7, and C8 during normal operation, and share one set of control system (unit), so as to reduce a hardware cost of the DCDC conversion module.

In some examples, the DCDC conversion module also includes: a leakage shunt resistor R5 at a side of the Battery2.

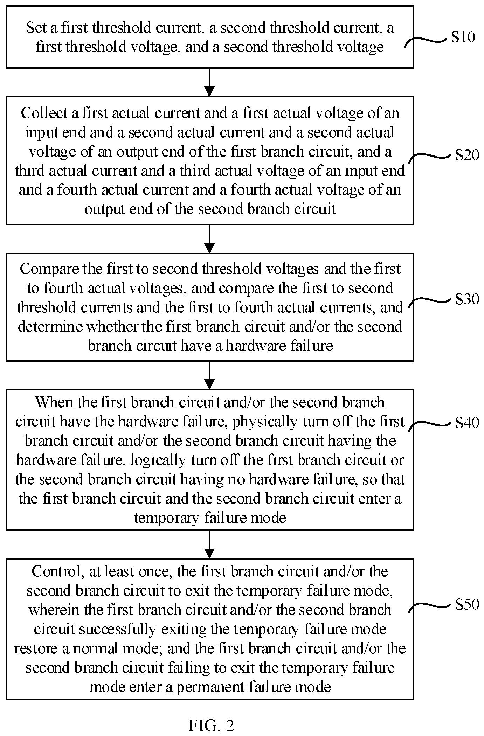

Referring to FIG. 2, FIG. 2 illustrates a flowchart of a hardware failure diagnosis method for a DCDC conversion module according to an embodiment of the present application. Based on the DCDC conversion module in an embodiment of the present application, this embodiment of the present application provides a hardware failure diagnosis method for a DCDC conversion module, including the following steps:

S10: set a first threshold current, a second threshold current, a first threshold voltage, and a second threshold voltage.

S20: collect a first actual current and a first actual voltage of an input as well as a second actual current and a second actual voltage of an output of the first branch 10, a third actual current and a third actual voltage of an input as well as a fourth actual current and a fourth actual voltage of an output of the second branch. Specifically, in the first branch 10, the first actual voltage is collected between the first input side switch unit 11 and the first input side shunt resistor R1, the first actual current is collected using the first input side shunt resistor R1, the second actual current is collected using the first output side shunt resistor R2, and the second actual current is collected between the first output side shunt resistor R2 and the first output side switch unit 13. In the second branch 20, the third actual voltage is collected between the second input side switch unit 21 and the second input side shunt resistor R3, the third actual current is collected using the second input side shunt resistor R3, the fourth actual current is collected using the second output side shunt resistor R4, and the fourth actual current is collected between the second output side shunt resistor R4 and the second output side switch unit 23.

S30: compare the first actual current and the third actual current with the first threshold current, compare the second actual current and the fourth actual current with the second threshold current, compare the first actual voltage and the third actual voltage with the first threshold voltage, and compare the second actual voltage and the fourth actual voltage with the second threshold voltage; if at least one of the first actual current or the third actual current is greater than the first threshold voltage, or if at least one of the first actual voltage or the third actual voltage is greater than the first threshold voltage, diagnose the hardware failure as occurring in the first branch 10; and if at least one of the second actual current or the fourth actual current is greater than the second threshold current, or if at least one of the second actual voltage or the fourth actual voltage is greater than the second threshold voltage, diagnose the hardware failure as occurring in the second branch 20. Specifically, the hardware failure includes: a hardware damage failure and a non-hardware damage failure.

S40: when the hardware failure occurs in the at least one of the first branch 10 or the second branch 20, physically turning off the at least one of the first branch 10 or the second branch 20 in which the hardware failure occurs; logically turning off the first branch 10 or the second branch 20 in which no hardware failure occurs, such that the first branch 10 and the second branch 20 both enter a temporary failure mode. Specifically, if the hardware failure occurs in only one branch, it is required to physically turn off the first branch 10 or the second branch 20 in which the hardware failure occurs. If the hardware failure occurs in the first branch 10, an operation of physically turning off the first branch 10 in which the hardware failure occurs may include: turning off the first input side switch unit 11 and the first output side switch unit 13 and turning off the first power conversion unit 12. Similarly, if the hardware failure occurs in the second branch 20, an operation of physically turning off the second branch 20 in which the hardware failure occurs may include: turning off the second input side switch unit 21 and the second output side switch unit 23 and turning off the second power conversion unit 22. In some examples, if the hardware failure occurs in both branches, it is required to physically turn off both the first branch 10 and the second branch 20 in which the hardware failure occurs, and an operation of physically turning off both of the branches may include: turning off the first input side switch unit 11 and the first output side switch unit 13, turning off the first power conversion unit 12, turning off the second input side switch unit 21 and the second output side switch unit 23, and turning off the second power conversion unit 22.

In some examples, if the hardware failure occurs in only one branch, it is required to logically turn off the first branch 10 or the second branch 20 in which no hardware failure occurs. Specifically, if no hardware failure occurs in the first branch 10, an operation of logically turning off the first branch 10 in which no hardware failure occurs may include: controlling the first input side switch unit 11 and the first output side switch unit 13 to be off and controlling the first power conversion unit 12 to stop outputting power. Similarly, if no hardware failure occurs in the second branch 20, an operation of logically turning off the second branch 20 in which no hardware failure occurs may include: controlling the second input side switch unit 21 and the second output side switch unit 23 to be off and controlling the second power conversion unit 22 to stop outputting power.

The temporary failure mode corresponds to the hardware failure, and therefore, the temporary failure mode may be a hardware damage failure or a non-hardware damage failure.

S50: control, at least once, the at least one of the first branch 10 or the second branch 20 to exit the temporary failure mode, where the at least one of the first branch 10 or the second branch 20 that succeeds in exiting the temporary failure mode recovers a normal mode, and the at least one of the first branch 10 or the second branch 20 that fails in exiting the temporary failure mode enters a permanent failure mode. Specifically, the controlling the at least one of the first branch 10 or the second branch 20 to exit the temporary failure mode includes: controlling the first input side switch unit 11 and the first output side switch unit 13 to be on and controlling the first power conversion unit 12 to output power normally, and/or controlling the second input side switch unit 21 and the second output side switch unit 23 to be on and controlling the second power conversion unit 22 to output power normally.

In some examples, In step S50, the step of controlling, at least once, the at least one of the first branch or the second branch to exit the temporary failure mode may specifically include:
the first step: setting a failure recovery count threshold;
the second step: respectively obtaining a first failure recovery count of the first branch 10 and a second failure recovery count of the second branch 20;
the third step: respectively comparing the first failure recovery count and the second failure recovery count with the count threshold, and performing the fourth step if at least one of the first failure recovery count or the second failure recovery count is less than or equal to the count threshold; performing the seventh step if the first failure recovery count and the second failure recovery count are both greater than the count threshold;
the fourth step: logically controlling the at least one of the first branch 10 or the second branch 20 to exit the temporary failure mode (which may specifically include controlling the first input side switch unit 11 and the first output side switch unit 13 to be on and controlling the first power conversion unit 12 to output power normally, and/or controlling the second input side switch unit 21 and the second output side switch unit 23 to be on and controlling the second power conversion unit 22 to output power normally), so as to recover normal operation of the at least one of the first branch 10 or the second branch 20, and if recovery of the normal operation of the at least one of the first branch 10 or the second branch 20 succeeds (exit from the temporary failure mode succeeds), diagnosing the temporary failure mode as the non-hardware damage failure, performing the fifth step, and adding 1 to the failure recovery count of the at least one of the first branch 10 or the second branch 20 at the same time; if the recovery of the normal operation of the at least one of the first branch 10 or the second branch 20 does not succeed (the exit from the temporary failure mode does not succeed), diagnosing the temporary failure mode as the hardware damage failure, and performing the seventh step;
the fifth step: comparing the first actual current and the third actual current with the first threshold current, comparing the second actual current and the fourth actual current with the second threshold current, comparing the first actual voltage and the third actual voltage with the first threshold voltage, and comparing the second actual voltage and the fourth actual voltage with the second threshold voltage; if at least one of the first actual current or the third actual current is greater than the first threshold voltage, or if at least one of the first actual voltage or the third actual voltage is greater than the first threshold voltage, or if at least one of the second actual current or the fourth actual current is greater than the second threshold current, or if at least one of the second actual voltage or the fourth actual voltage is greater than the second threshold voltage, returning to the second step; and if the first actual current and the third actual current are less than equal to the first threshold voltage, the first actual voltage and the third actual voltage are less than equal to the first threshold voltage, the second actual current and the fourth actual current are less than equal to the second threshold current, and the second actual voltage and the fourth actual voltage are less than equal to the second threshold voltage, performing the sixth step;
the sixth step: recovering the normal mode of the at least one of the first branch 10 or the second branch 20 that succeeds in exiting the temporary failure mode, and setting the failure recovery count of the at least one of the first branch 10 or the second branch 20 to zero at the same time; and
the seventh step: entering the permanent failure mode of the at least one of the first branch 10 or the second branch 20 that fails in exiting the temporary failure mode.

In this embodiment, in the above step of controlling, at least once, the at least one of the first branch or the second branch to exit the temporary failure mode, the first branch 10 or the second branch 20 that succeeds in exiting the temporary failure mode no longer performs a failure recovery operation and directly enables the normal operation to output power normally.

In some examples, after the recovering the normal mode of the first branch 10 or the second branch 20 that succeeds in exiting the temporary failure mode, the hardware failure diagnosis method for a DCDC conversion module also includes: halving a value of preset maximum desired output power in the DCDC conversion module.

Power outputs of two circuits (the first branch 10 and the second branch 20) in the DCDC conversion module of this embodiment of the present application are relatively independent, and the two circuits have same power conversion units (the first power conversion unit 12 and the second power conversion unit 22), referring to FIG. 1. The first branch 10 and the second branch 20 share the same input voltage source, but have independent voltage and current sampling circuits that connect the outputs in parallel, such that under a normal operating condition, the output power of each circuit is a half of total output power. Under an abnormal operating condition (where any one of the circuits is incapable of an output due to a failure), a non-failurey circuit can is capable of a normal output, with maximum output power being a half of the total maximum output power.

A topology in the DCDC conversion module of this embodiment of the present application does not require an extra hardware cost relative to the conventional solution (II). Since the two circuits are independent relatively rather than completely, it is just required to divide an original single-circuit output topology into two parts, in which case some external circuits and control switches are required, which, however, may be controlled with only a single control unit, thereby reducing the hardware cost.

In the hardware failure diagnosis method for a DCDC conversion module provided by the present application, failure diagnoses for the two circuits are independent relatively. The two circuits have identical switch units (the first input side switch unit 11, the first output side switch unit 13, the second input side switch unit 21, and the second output side switch unit 23). The inputs and outputs of the two circuits are controlled by corresponding switch units, such as N1/N31/N32 in the first branch 10 and N4/N61/N62 in the second branch 20 referring to FIG. 1. Safety switches of the two circuits perform control independent, i.e., when a hardware failure occurs in any one of the circuits, input and output side switch units of the circuit in which the hardware failure occurs is turned off, while input and output side switch units of a normal circuit remain in an on state. The hardware failure diagnosis method for a DCDC conversion module of the present application can enable a quick response to and recovery from a hardware failure in the DCDC conversion module of a vehicle start-stop system, thereby ensuring the traveling safety of the entire vehicle and improving the hardware failure diagnosis efficiency.

In some examples, upon entry of the at least one of the first branch or the second branch into the permanent failure mode, the DCDC conversion module obtains an off state of the at least one of the first branch or the second branch and feeds back the off state to a Vehicle control unit; and when the at least one of the first branch or the second branch succeeds in recovering the normal mode, the DCDC conversion module obtains a failure recovery state of the at least one of the first branch or the second branch and feeds back the failure recovery state to the Vehicle control unit, such that the Vehicle control unit can perform operations such as output power constraint according to actual situations, as well as fast and accurate failure localization and device repair in conjunction with the failure state.

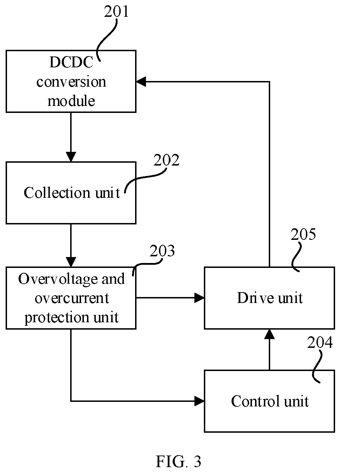

Based on the same inventive concept, embodiments of the present application also provide a hardware failure diagnosis apparatus for a DCDC conversion module. Referring to FIG. 3, FIG. 3 illustrates a schematic diagram of a structure of a hardware failure diagnosis apparatus for a DCDC conversion module according to an embodiment of the present application. The DCDC conversion module 201 includes: a first branch 10 and a second branch 20 connected in parallel. The hardware failure diagnosis apparatus for the DCDC conversion module includes:
a collection unit 202 configured to collect a first actual current and a first actual voltage of an input as well as a second actual current and a second actual voltage of an output of the first branch 10, a third actual current and a third actual voltage of an input as well as a fourth actual current and a fourth actual voltage of an output of the second branch 20;
an overvoltage and overcurrent protection unit 203 configured to compare the first to second threshold voltages with the first to fourth actual voltages, compare the first to second threshold currents with the first to fourth actual currents, to determine whether a hardware failure occurs in at least one of the first branch 10 or the second branch 20, and output a failure signal to a rear stage if the hardware failure occurs;
a control unit 204 configured to control logic turning-off of the first branch 10 or the second branch 20, and control, at least once, the at least one of the first branch 10 or the second branch 20 to exit a temporary failure mode; and
a drive unit 205 configured to receive the failure signal sent by the overvoltage and overcurrent protection unit 203, physically turn off the at least one of the first branch 10 or the second branch 20 in which the hardware failure occurs, receive a first control signal sent by the control unit 204 to logically turn off the first branch 10 or the second branch 20 in which no hardware failure occurs, and receive a second control signal sent by the control unit 204 to control, at least once, the at least one of the first branch 10 or the second branch 20 to exit the temporary failure mode. That is, the drive unit 205 may receive the first control signal and the second control signal, and send an off/on control signal to at least one of the first branch 10 or the second branch 20.

Based on the same inventive concept, embodiments of the present application also provide a computer-readable storage medium, the storage medium having at least one instruction, at least one program, a code set, or an instruction set stored therein, the at least one instruction, the at least one program, the code set, or the instruction set being loaded and executed by a processor to implement the hardware failure diagnosis method for a DCDC conversion module.

Obviously, the above embodiments are merely examples listed for clear descriptions, rather than for limitations to the implementations. A person skilled in the art may also make other changes or modifications in different forms on the basis of the above descriptions. There is no need or way to exhaustively list all of the implementations herein, but obvious changes or modifications derived herefrom still fall into the scope of protection created by the present application.

## Claims

1. A hardware failure diagnosis method for a DCDC conversion module, the DCDC conversion module comprising: a first branch and a second branch connected in parallel; the hardware failure diagnosis method for the DCDC conversion module comprising:
setting a first threshold current, a second threshold current, a first threshold voltage, and a second threshold voltage;
collecting a first actual current and a first actual voltage of an input as well as a second actual current and a second actual voltage of an output of the first branch, a third actual current and a third actual voltage of an input as well as a fourth actual current and a fourth actual voltage of an output of the second branch;
comparing the first to second threshold voltages with the first to fourth actual voltages, and comparing the first to second threshold currents with the first to fourth actual currents, to determine whether a hardware failure occurs in at least one of the first branch or the second branch;
when the hardware failure occurs in the at least one of the first branch or the second branch, physically turning off the at least one of the first branch or the second branch in which the hardware failure occurs; logically turning off the first branch or the second branch in which no hardware failure occurs, such that the first branch and the second branch both enter a temporary failure mode; and
controlling, at least once, the at least one of the first branch or the second branch to exit the temporary failure mode, wherein the at least one of the first branch or the second branch that succeeds in exiting the temporary failure mode recovers a normal mode, and the at least one of the first branch or the second branch that fails in exiting the temporary failure mode enters a permanent failure mode.

2. The hardware failure diagnosis method for a DCDC conversion module according to claim 1, wherein the hardware failure comprises: a hardware damage failure and a non-hardware damage failure.

3. The hardware failure diagnosis method for a DCDC conversion module according to claim 2, wherein the step of controlling, at least once, the at least one of the first branch or the second branch to exit the temporary failure mode comprises:
the first step: setting a failure recovery count threshold;
the second step: respectively obtaining a first failure recovery count of the first branch and
a second failure recovery count of the second branch;
the third step: respectively comparing the first failure recovery count and the second failure recovery count with the count threshold, and performing the fourth step if at least one of the first failure recovery count or the second failure recovery count is less than or equal to the count threshold; performing the seventh step if the first failure recovery count and the second failure recovery count are both greater than the count threshold;
the fourth step: performing an attempt to recover normal operation of the at least one of the first branch or the second branch, and if recovery of the normal operation of the at least one of the first branch or the second branch succeeds, diagnosing the temporary failure mode as the non-hardware damage failure, performing the fifth step, and adding 1 to the failure recovery count of the at least one of the first branch or the second branch at the same time; if the recovery of the normal operation of the at least one of the first branch or the second branch does not succeed, diagnosing the temporary failure mode as the hardware damage failure, and performing the seventh step;
the fifth step: monitoring whether there is an anomaly in any one or multiple parameters among the first to fourth actual voltages and the first to fourth actual currents are abnormal, and returning to the second step if there is an anomaly in any one or multiple parameters among the first to fourth actual voltages and the first to fourth actual currents; performing the sixth step if all parameters are normal;
the sixth step: recovering the normal mode of the at least one of the first branch or the second branch that succeeds in exiting the temporary failure mode, and setting the failure recovery count of the at least one of the first branch or the second branch to zero at the same time; and
the seventh step: entering the permanent failure mode of the at least one of the first branch or the second branch that fails in exiting the temporary failure mode.

4. The hardware failure diagnosis method for a DCDC conversion module according to claim 1, after recovering the normal mode of the first branch or the second branch that succeeds in exiting the temporary failure mode, also comprising:
halving a value of preset maximum desired output power in the DCDC conversion module.

5. The hardware failure diagnosis method for a DCDC conversion module according to claim 1, wherein the first branch comprises: a first input side switch unit, a first power conversion unit, and a first output side switch unit connected in sequence; the second branch comprises: a second input side switch unit, a second power conversion unit, and a second output side switch unit connected in sequence.

6. The hardware failure diagnosis method for a DCDC conversion module according to claim 5, wherein the controlling the at least one of the first branch or the second branch to exit the temporary failure mode comprises: controlling the first input side switch unit and the first output side switch unit to be on and controlling the first power conversion unit to output power normally, and/or controlling the second input side switch unit and the second output side switch unit to be on and controlling the second power conversion unit to output power normally.

7. The hardware failure diagnosis method for a DCDC conversion module according to claim 5, wherein the physically turning off the at least one of the first branch or the second branch in which the hardware failure occurs comprises: turning off the first input side switch unit and the first output side switch unit and turning off the first power conversion unit, and/or turning off the second input side switch unit and the second output side switch unit and turning off the second power conversion unit;
the logically turning off the first branch or the second branch in which no hardware failure occurs comprises: controlling the first input side switch unit and the first output side switch unit to be off and controlling the first power conversion unit to stop outputting power, and/or controlling the second input side switch unit and the second output side switch unit to be off and controlling the second power conversion unit to stop outputting power.

8. The hardware failure diagnosis method for a DCDC conversion module according to claim 1, wherein the step of comparing the first to second threshold voltages with the first to fourth actual voltages, and comparing the first to second threshold currents with the first to fourth actual currents, to determine whether a hardware failure occurs in at least one of the first branch or the second branch comprises:
comparing the first actual current and the third actual current with the first threshold current, comparing the second actual current and the fourth actual current with the second threshold current, comparing the first actual voltage and the third actual voltage with the first threshold voltage, and comparing the second actual voltage and the fourth actual voltage with the second threshold voltage; if at least one of the first actual current or the third actual current is greater than the first threshold voltage, or if at least one of the first actual voltage or the third actual voltage is greater than the first threshold voltage, diagnosing the hardware failure as occurring in the first branch; and if at least one of the second actual current or the fourth actual current is greater than the second threshold current, or if at least one of the second actual voltage or the fourth actual voltage is greater than the second threshold voltage, diagnosing the hardware failure as occurring in the second branch.

9. The hardware failure diagnosis method for a DCDC conversion module according to claim 3, wherein the fifth step in the step of controlling, at least once, the at least one of the first branch or the second branch to exit the temporary failure mode comprises:
comparing the first actual current and the third actual current with the first threshold current, comparing the second actual current and the fourth actual current with the second threshold current, comparing the first actual voltage and the third actual voltage with the first threshold voltage, and comparing the second actual voltage and the fourth actual voltage with the second threshold voltage; if at least one of the first actual current or the third actual current is greater than the first threshold voltage, or if at least one of the first actual voltage or the third actual voltage is greater than the first threshold voltage, or if at least one of the second actual current or the fourth actual current is greater than the second threshold current, or if at least one of the second actual voltage or the fourth actual voltage is greater than the second threshold voltage, returning to the second step; and if the first actual current and the third actual current are less than equal to the first threshold voltage, the first actual voltage and the third actual voltage are less than equal to the first threshold voltage, the second actual current and the fourth actual current are less than equal to the second threshold current, and the second actual voltage and the fourth actual voltage are less than equal to the second threshold voltage, performing the sixth step.

10. The hardware failure diagnosis method for a DCDC conversion module according to claim 1, wherein upon entry of the at least one of the first branch or the second branch into the permanent failure mode, the DCDC conversion module obtains an off state of the at least one of the first branch or the second branch and feeds back the off state to a vehicle control unit; and when the at least one of the first branch or the second branch succeeds in recovering the normal mode, the DCDC conversion module obtains a failure recovery state of the at least one of the first branch or the second branch and feeds back the failure recovery state to the vehicle control unit.

11. The hardware failure diagnosis method for a DCDC conversion module according to claim 1, wherein the DCDC conversion module also comprises: a first transient current suppression module and a second transient current suppression module, the first transient current suppression module being connected to inputs of the first branch and the second branch connected in parallel, and the second transient current suppression module being connected to outputs of the first branch and the second branch connected in parallel.

12. A hardware failure diagnosis apparatus for a DCDC conversion module, the DCDC conversion module comprising: a first branch and a second branch connected in parallel; the hardware failure diagnosis apparatus for the DCDC conversion module comprising:
a collection unit configured to collect a first actual current and a first actual voltage of an input as well as a second actual current and a second actual voltage of an output of the first branch, a third actual current and a third actual voltage of an input as well as a fourth actual current and a fourth actual voltage of an output of the second branch;
an overvoltage and overcurrent protection unit configured to compare the first to second threshold voltages with the first to fourth actual voltages, compare the first to second threshold currents with the first to fourth actual currents, to determine whether a hardware failure occurs in at least one of the first branch or the second branch, and output a failure signal to a rear stage if the hardware failure occurs;
a control unit configured to control logic turning-off of the first branch or the second branch, and control, at least once, the at least one of the first branch or the second branch to exit a temporary failure mode; and
a drive unit configured to receive the failure signal sent by the overvoltage and overcurrent protection unit, physically turn off the at least one of the first branch or the second branch in which the hardware failure occurs, receive a first control signal sent by the control unit to logically turn off the first branch or the second branch in which no hardware failure occurs, and receive a second control signal sent by the control unit to control, at least once, the at least one of the first branch or the second branch to exit the temporary failure mode.

13. A computer-readable storage medium, the storage medium having at least one instruction, at least one program, a code set, or an instruction set stored therein, the at least one instruction, the at least one program, the code set, or the instruction set being loaded and executed by a processor to implement the hardware failure diagnosis method for a DCDC conversion module according to any one of claims 1 to 11.
